(19) Europäisches Patentamt
European Patent Office
Office européen des brevets

(11) **EP 1 484 911 B1**

(12) **FASCICULE DE BREVET EUROPEEN**

(45) Date de publication et mention
de la délivrance du brevet:
**20.08.2008 Bulletin 2008/34**

(51) Int Cl.:
*H04N 5/235* (2006.01)   *H04N 5/335* (2006.01)
*H03M 1/18* (2006.01)

(21) Numéro de dépôt: **04011630.3**

(22) Date de dépôt: **17.05.2004**

(54) **Dispositif et procédé de conversion analogique numérique surnuméraire adaptatif pour un capteur d' image**

Adaptive redundante A/D Umsetzungsvorrichtung und -verfahren für Bildaufnahmesensor

Adaptive redundant analog-to-digital conversion device and method for image sensor

(84) Etats contractants désignés:
**AT BE BG CH CY CZ DE DK EE ES FI FR GB GR HU IE IT LI LU MC NL PL PT RO SE SI SK TR**

(30) Priorité: **03.06.2003 EP 03012594**

(43) Date de publication de la demande:
**08.12.2004 Bulletin 2004/50**

(73) Titulaire: **ASULAB S.A.**
**2074 Marin (CH)**

(72) Inventeurs:
• **Aeby, Fabien**
**1580 Avenches (CH)**
• **Genilloud, Laurent**
**1680 Romont (CH)**

(74) Mandataire: **Laurent, Jean et al**
**I C B**
**Ingénieurs Conseils en Brevets SA**
**Rue des Sors 7**
**2074 Marin (CH)**

(56) Documents cités:
**EP-A- 0 567 145**          **US-A- 4 733 217**
**US-A1- 2002 140 842**

**EP 1 484 911 B1**

**Description**

L'invention concerne un dispositif de conversion analogique numérique de type surnuméraire adaptatif. De préférence, le dispositif de conversion permet de convertir numériquement des signaux produits par une cellule photosensible d'un capteur d'image. La cellule photosensible est composée d'une matrice de pixels.

Le dispositif de conversion comprend donc au moins un premier convertisseur à N bits recevant un signal de tension ou de courant d'un pixel, et au moins un second convertisseur à M bits connecté au premier convertisseur. Les premier et second convertisseurs permettent de convertir le niveau de tension ou de courant du pixel sur N+M bits. Le niveau de tension ou de courant du signal produit par chaque pixel est dépendant d'un niveau de lumière captée par le pixel dans une gamme dynamique déterminée de tension ou de courant du capteur.

Le premier convertisseur du dispositif comprend des moyens de comparaison pour comparer le niveau de tension ou de courant du pixel avec un ou plusieurs seuils de tension ou de courant. Ces seuils de tension ou de courant délimitent des plages successives de tension ou de courant dans la gamme dynamique. Les plages successives de tension ou de courant dans la gamme dynamique permettent de définir l'illumination d'un pixel allant d'un pixel faiblement illuminé à un pixel fortement illuminé. Le premier convertisseur fournit ainsi un mot binaire à N bits dont la valeur est relative à la plage de tension ou de courant où se situe le niveau de tension ou de courant du pixel.

Une conversion surnuméraire signifie qu'il est opéré une conversion avec un nombre de bits plus important que le nombre de bits conservés de chaque pixel après l'opération de conversion. De cette manière, il est possible d'opérer une amplification numérique en fonction du niveau d'illumination des pixels.

L'invention concerne également un capteur d'image comprenant notamment la cellule photosensible à matrice de pixels, le dispositif de conversion analogique-numérique relié à la cellule, un moyenneur d'illumination relié au dispositif de conversion et un adaptateur d'échelle relié au dispositif de conversion et au moyenneur.

L'invention concerne également un procédé de conversion analogique numérique pour la mise en action du dispositif de conversion analogique-numérique.

Pour capter une image, une cellule photosensible comprend généralement une matrice de pixels afin de fournir chacun des signaux convertis par exemple en tension représentant le nombre de photons captés. Plus ce nombre de photons est important et plus l'écart de tension produit est important. Habituellement, une image numérique est quantifiée sur 8 bits, soit 256 niveaux possibles. Dans le cas d'une image couleur, chaque composante primaire (rouge, verte, bleue) est codée sur 8 bits.

A ce titre, il est utile de rappeler que chaque pixel comprend une capacité à jonction, telle qu'une photodiode, pour capter des photons, notamment avec un puits de 100'000 électrons. En fonctionnement normal, cette capacité ou photodiode est inversement polarisée à une tension donnée par exemple entre 0 et 2 V.

Dans un capteur d'image du type APS (Active-Pixel Sensor en terminologie anglaise) réalisé dans une technologie CMOS, les photons déchargent une capacité en générant des paires électron-trou. Ces paires électron-trou sont collectées par les électrodes opposées de la capacité et par conséquent réduisent l'écart de tension aux bornes de la capacité. Comme cet écart de tension décroît avec l'illumination, il est prévu d'inverser la polarité du signal de manière à avoir une tension importante quand l'illumination du pixel est importante et une tension faible en cas de faible illumination. Ainsi, la gamme dynamique de tension du capteur est inférieure à la tension de polarisation de la capacité, par exemple égale à 1,5 V. Cette condition n'est cependant pas limitative.

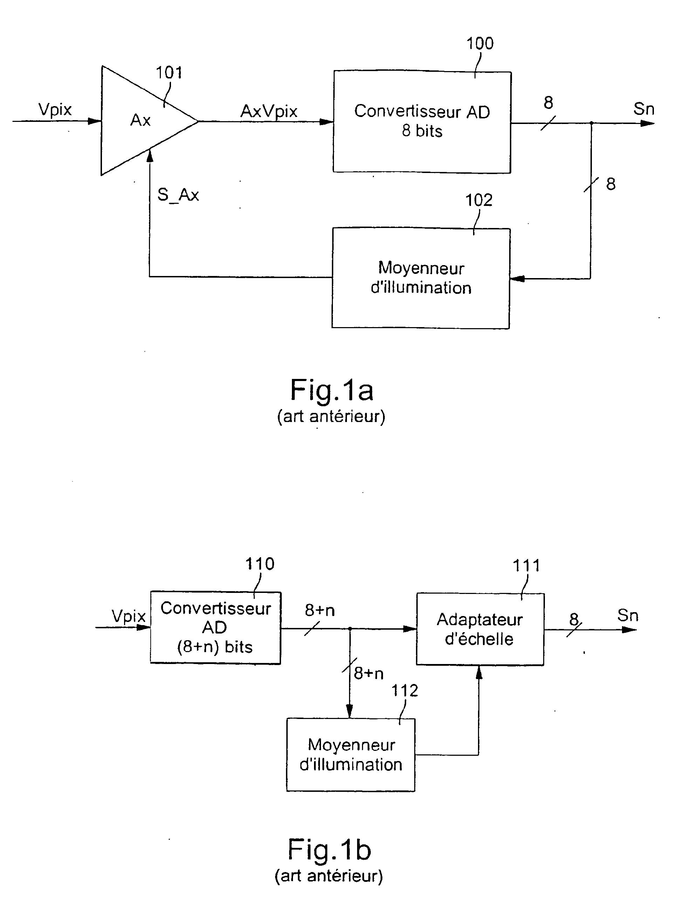

Lors de la conversion des signaux de tension produits par les pixels, une amplification de ces signaux doit en général être effectuée. Cette amplification est dépendante du niveau de l'illumination des pixels de l'image captée. Pour réaliser cette amplification des signaux, il peut être prévu d'opérer par exemple une pré-amplification de chaque signal des pixels avant l'opération de conversion analogique-numérique comme montré schématiquement à la figure 1a. Pour ce faire dans le capteur d'image, un certain nombre d'amplificateurs à gain variable 101 sont par exemple connectés chacun en sortie d'un pixel respectif non représenté pour recevoir une tension convertie Vpix correspondant à l'illumination captée. L'amplificateur à gain variable 101 pour chaque pixel amplifie la tension sensiblement constante Vpix par un facteur d'amplification Ax afin de fournir en sortie un signal de tension amplifié AxVpix. Le signal amplifié est ensuite converti numériquement dans un convertisseur AD standard à 8 bits 100 pour produire un mot binaire à 8 bits Sn.

Le facteur d'amplification Ax des amplificateurs est ajusté à la gamme dynamique du convertisseur après avoir effectué une moyenne de niveaux d'illumination notamment de certains pixels. Cette moyenne est effectuée à l'aide d'un moyenneur d'illumination 102 relié dans une boucle de contre-réaction entre le convertisseur 100 et le ou les amplificateurs 101. Un signal de commande S_Ax est fourni par le moyenneur à l'amplificateur pour ajuster ce facteur d'amplification.

Pour fixer ce facteur d'amplification, il est nécessaire d'effectuer plusieurs conversions analogiques-numériques afin d'atteindre un état optimal de la moyenne d'illumination de l'image captée par les pixels ce qui est un inconvénient. Un autre inconvénient avec une amplification analogique de la tension de chaque pixel est que cela engendre une forte consommation d'énergie due notamment à un surplus de travail du capteur d'image. Ceci rend donc difficile une utilisation d'un tel capteur dans un objet portable, tel qu'une montre-bracelet, qui est alimenté par des piles ou des accumulateurs de petite taille. De plus, il est difficile de paralléliser plusieurs amplificateurs analogiques appariés dans une même structure semi-conductrice pour gagner du temps de conversion d'une image captée par la matrice de pixels.

Une autre solution pour amplifier les signaux des pixels consiste à opérer une amplification numérique à l'aide d'un convertisseur analogique-numérique du type surnuméraire d'un capteur d'image comme représenté schématiquement à la figure 1 b. Pour cette amplification numérique, la tension convertie Vpix par chaque pixel est tout d'abord numérisée à l'aide d'un dispositif de conversion ou convertisseur AD surnuméraire à 8+n bits 110. Le mot binaire produit par le convertisseur 110 est fourni à un adaptateur d'échelle 111 qui est chargé de prélever les mêmes 8 bits successifs de chaque mot binaire à 8+n bits et de fournir un signal binaire Sn à 8 bits. Le choix des 8 bits successifs prélevés de chaque mot binaire est dépendant d'une moyenne d'illumination d'un sous-ensemble de pixels de la matrice ayant captée une image à numériser. Cette moyenne d'illumination est réalisée par un moyenneur d'illumination 112. Ce moyenneur d'illumination 112 fait par exemple une moyenne sur plusieurs mots binaires à 8+n bits du convertisseur 110 afin de déterminer quels sont les bits les plus représentatifs des signaux de tension Vpix numérisés.

Ainsi avec cette amplification numérique, il est possible de différer la prise de décision concernant le niveau d'illumination moyen de l'image captée par la matrice de pixels, ce qui évite un contrôle d'exposition préalable comme c'est le cas avec une amplification analogique. Cependant avec un tel dispositif de conversion 110 standard, une conversion à 8+n bits est effectuée dans tous les cas d'illumination des pixels, ce qui peut être un inconvénient. Cette conversion avec ce surplus de précision n'est pas toujours nécessaire notamment lors d'une forte illumination des pixels de la cellule photosensible, car le bruit du capteur d'image provenant de la cellule photosensible est plus important en forte illumination qu'en faible illumination. Il se peut donc que, lors de la détermination des bits de poids faibles d'un pixel fortement illuminé, le convertisseur convertisse des niveaux de tension ou de courant plus faibles que le bruit du pixel. Ceci rend cette opération superflue, puisque aléatoire, ce qui est un inconvénient.

On peut citer à ce titre le brevet US 4,733,217 qui décrit un dispositif de conversion analogique-numérique à sous-gammes. Ce dispositif de conversion comprend un premier convertisseur grossier à N bits, qui reçoit un signal vidéo de tension ou de courant, et un second convertisseur fin à M bits connecté au premier convertisseur. Les N bits fournis par le premier convertisseur déterminent une plage de tension ou de courant dans laquelle se trouve le signal de tension ou de courant dans une gamme dynamique de tension ou de courant. Cette plage est déterminée dans le premier convertisseur après des opérations de comparaison du signal avec des seuils de tension ou de courant. Un élément de combinaison, connecté aux premier et second convertisseurs, reçoit les N bits MSB du premier convertisseur et les M bits LSB du second convertisseur pour fournir un mot binaire à N+M bits.

Un inconvénient d'un tel dispositif de conversion du brevet susmentionné est qu'il n'est pas en mesure d'adapter la conversion du signal de tension ou de courant en fonction du niveau de tension ou de courant dudit signal analogique à convertir.

L'invention a donc pour but principal de pallier les inconvénients de l'art antérieur en fournissant un dispositif de conversion analogique-numérique surnuméraire qui peut être adapté selon le niveau d'illumination de chaque pixel de la cellule photosensible. Le dispositif de conversion est par exemple adapté de manière à ne pas convertir inutilement du bruit lors d'une prise d'image par la cellule photosensible.

A cet effet, l'invention a pour objet un dispositif de conversion analogique-numérique cité ci-devant qui se caractérise en ce que le second convertisseur comprend des moyens d'adaptation de conversion qui sont configurés par la plage de tension ou de courant déterminée entre une tension minimale ou un courant minimal et une tension maximale ou un courant maximal de ladite plage de tension ou de courant en fonction de la valeur du mot binaire à N bits de poids fort fourni par le premier convertisseur, les moyens d'adaptation de conversion étant configurés pour effectuer une conversion du signal de tension ou de courant du pixel sur un nombre de bits de poids faible inférieur à M sans convertir le ou les derniers bits de poids le plus faible pour une plage de tension ou de courant déterminée d'un pixel fortement illuminé ou égal à M pour une plage de tension ou de courant déterminée d'un pixel qui est faiblement illuminé.

Un avantage du dispositif de conversion analogique-numérique, selon l'invention, réside dans le fait que les moyens d'adaptation du second convertisseur permettent de ne convertir que le signal utile fourni par chaque pixel en évitant de convertir inutilement du bruit lors de la prise d'image par la cellule photosensible. Le second convertisseur est adapté en fonction du mot binaire produit par le premier convertisseur pour opérer une conversion sans surplus de précision. Ce mot binaire fourni par le premier convertisseur est dépendant du niveau de tension ou de courant de chaque pixel afin de déterminer une zone d'illumination de chaque pixel. De ce fait, cela permet de diminuer la consommation d'énergie notamment du dispositif lors des étapes de conversion de chaque signal de tension ou de courant fourni par les pixels.

De préférence, comme le bruit en forte illumination est approximativement 8 fois plus important qu'en faible illumination, les pixels faiblement éclairés doivent être plus finement convertis que les pixels moyennement ou fortement éclairés. Il est donc défini des plages de tension de taille différente dans la gamme dynamique représentant chacune une zone d'illumination déterminée en fonction de la différence de bruit. Ceci permet d'opérer une amplification numérique par exemple 8 fois plus importante des signaux des pixels faiblement éclairés que ceux fortement éclairés.

Dans le cas d'une prise d'image par une cellule photosensible d'un capteur d'image du type APS CMOS, le bruit est proche de 1 mV à faible illumination, alors qu'il peut valoir près de 8 mV à forte illumination. Pour éviter que la sortie finale à 8 bits ne contiennent des bits de bruit, il faut prévoir une amplification numérique d'un facteur 8 correspondant à 3 bits supplémentaires. Dans ce cas de conversion linéaire à 11 bits (N+M+1 bits), la résolution du dernier bit de poids faible est constante sur toute la gamme dynamique et est rapidement noyée dans le bruit. Lorsque le pixel se trouve dans une zone à forte illumination, les trois derniers bits de poids faible ne contiennent plus d'information et leur traitement est donc inutile.

Il est possible de réduire le nombre de bits à convertir en dé-linéarisant le premier convertisseur à N bits. En sachant que le second convertisseur traite jusqu'à M bits de manière linéaire (à gain constant), on fixe la taille de la zone de faible illumination afin que la précision du dernier bit de poids faible soit équivalente à un convertisseur linéaire standard à N+M+1 bits sur toute la gamme dynamique. Par contre en cas de forte illumination, le dernier bit converti doit être 8 fois moins sensible que le dernier bit en faible illumination. Le second convertisseur ne convertit donc que sur un nombre de bits inférieur à M afin de gagner également du temps de conversion et de réduire la consommation d'énergie électrique.

Il faut donc un facteur 2 supplémentaire entre le gain de conversion à faible illumination et celui en forte illumination. Par conséquent, les zones de forte illumination sont deux fois plus étendues que celle de faible illumination. Pour les cas intermédiaires, une zone de taille légèrement supérieure à la zone de faible illumination est convenable.

L'invention a également pour objet un capteur d'image, qui comprend les caractéristiques mentionnées dans la revendication 9.

Un avantage d'un tel capteur d'image, selon l'invention, réside dans le fait qu'en diminuant le temps de conversion avec un dispositif de conversion ayant plusieurs premier et second convertisseurs placés en parallèle de structures lentes et bien optimisées, la consommation électrique peut être fortement réduite. Toutefois en parallélisant plusieurs dizaines de premier et second convertisseurs, la technologie CMOS actuelle pour la réalisation de tels circuits intégrés, ne permet pas de réaliser des convertisseurs de plus de 10 bits en conservant une taille raisonnable. De ce fait, il est nécessaire pour des pixels faiblement éclairés d'opérer une conversion fine dans la première plage de tension par le second convertisseur avec une précision de conversion qui correspond à celle d'un convertisseur linéaire à 11 bits standard sur toute la gamme dynamique de tension du capteur.

L'invention a également pour objet un procédé de conversion analogique-numérique, qui comprend les caractéristiques mentionnées dans la revendication 11.

Les buts, avantages et caractéristiques du dispositif de conversion analogique-numérique, ainsi que le capteur d'image et le procédé de mise en action du dispositif apparaîtront mieux dans la description suivante de modes de réalisation de l'invention en liaison avec les dessins dans lesquels :

La figure 1a déjà citée représente schématiquement une partie de conversion analogique-numérique d'un capteur d'image avec une amplification analogique à gain variable de la tension fournie par chaque pixel selon l'art antérieur,
la figure 1b déjà citée représente schématiquement une partie de conversion analogique-numérique d'un capteur d'image avec une amplification numérique après la phase de conversion selon l'art antérieur,
la figure 2 représente schématiquement un ensemble de prise d'image destiné à équiper un objet portable, tel qu'une montre-bracelet, qui comprend un dispositif de conversion analogique-numérique surnuméraire adaptatif selon l'invention,
la figure 3 représente un graphique de la tension efficace de bruit en fonction du potentiel de la gamme dynamique du capteur d'image,
la figure 4 représente schématiquement le dispositif de conversion analogique-numérique avec les premier et second convertisseurs selon l'invention,
la figure 5 représente de manière plus détaillée le dispositif de conversion analogique-numérique avec des composants combinés pour les premier et second convertisseurs,
la figure 6 représente une partie du second convertisseur, qui comprend un réseau de capacités commutables pondérées en puissance de 2 et le circuit de commutation,
les figures 7a et 7b représentent d'une part un graphique de la fonction de transfert du premier convertisseur, définissant les zones d'illumination en fonction des seuils de tension de la gamme dynamique de tension, et d'autre part un registre pour chaque mot binaire à 10 bits fourni après les opérations de conversion des premier et second convertisseurs, et
la figure 8 représente des étapes (algorithme) du procédé de conversion analogique-numérique dans un dispositif de conversion selon l'invention.

Dans la description suivante, tous les composants électroniques du dispositif de conversion analogique-numérique surnuméraire, ainsi que les étapes de conversion, qui sont bien connus d'un homme du métier dans ce domaine technique, ne seront pas expliqués en détail.

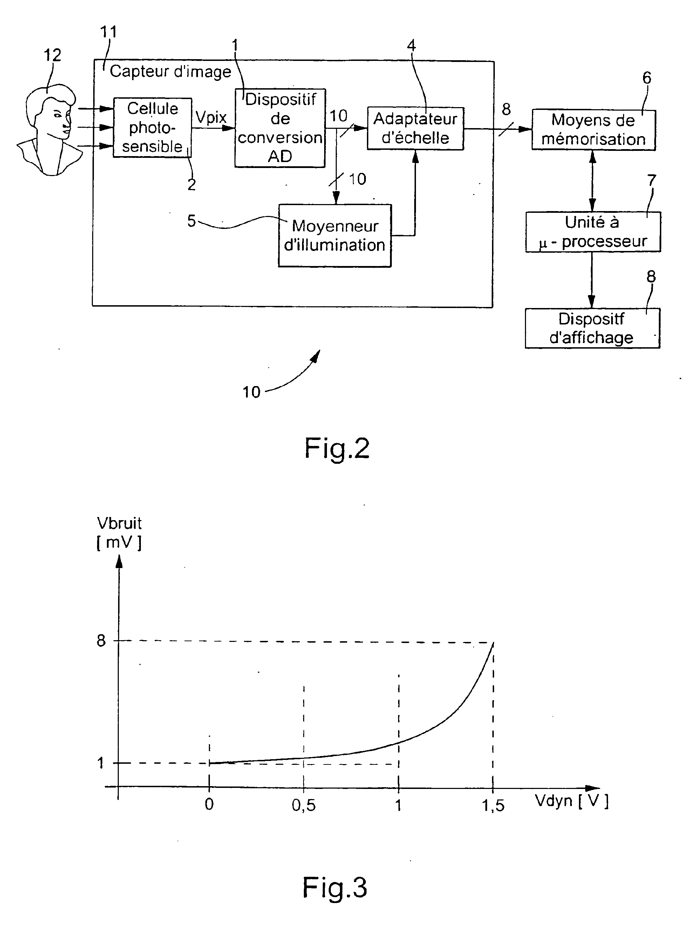

A la figure 2, un ensemble de prise d'image 10, notamment du type APS, est représenté dans lequel est disposé un dispositif de conversion analogique-numérique surnuméraire 1 selon l'invention. L'ensemble comprend essentiellement un capteur. d'image 11, qui est composé d'une cellule photosensible à matrice de pixels 2 pour capter une image 12, le dispositif de conversion analogique-numérique 1 des signaux fournis par les pixels du capteur, un moyenneur d'illumination 5, un adaptateur d'échelle 4, des moyens de mémorisation de l'image numérisée 6, une unité à microprocesseur 7 et un dispositif d'affichage de l'image captée 8. La matrice de pixels d'un capteur d'image APS VGA (Video Graphics Array en terminologie anglaise) est composée par exemple de 640 par 480 pixels fonctionnant dans une gamme dynamique d'approximativement 1,5 V.

Le dispositif de conversion 1, objet de l'invention, fournit des mots binaires à 10 bits relatifs à la conversion de signaux de tension produits par des pixels de la cellule 2. Ces mots binaires peuvent être mémorisés après les opérations de conversion successives ou en parallèle chacun dans des registres correspondants non représentés du dispositif 1. Le moyenneur d'illumination 5 reçoit donc un certain nombre de mots binaires à 10 bits provenant par exemple des registres du dispositif afin de déterminer une moyenne d'illumination desdits mots binaires.

En fonction du résultat de la moyenne opérée dans le moyenneur d'illumination 5, l'adaptateur d'échelle 4 reçoit un signal de commande du moyenneur 5. Ainsi, l'adaptateur configuré par le moyenneur 5 sélectionne 8 bits successifs les plus représentatifs parmi les 10 bits de chaque mot binaire produit par le dispositif de conversion analogique-numérique 1, en fonction du niveau d'illumination moyen de l'image captée. Pour une forte illumination d'une image captée par les pixels de la cellule photosensible 2, il n'est conservé que les 8 bits de poids fort de chaque mot binaire, alors que pour une faible illumination, il n'est conservé que les 8 bits de poids faible.

Tous les signaux de tension ou de courant des pixels numérisés sur 8 bits sont par la suite mémorisés dans des moyens de mémorisation 6, tels qu'une mémoire non volatile de type EEPROM, sous la commande de l'unité à microprocesseur 7. L'unité à microprocesseur 7 exécute de manière connue des calculs spécifiques pour mémoriser dans les moyens de mémorisation 6 tous les octets de la matrice de pixels selon un format déterminé. Ce format peut être par exemple le format JPEG (Joint Photographic Experts Group en terminologie anglaise). L'image ainsi mémorisée peut être visionnée sur le dispositif d'affichage 8 qui peut être un écran LCD couleur.

Comme le bruit produit notamment par la cellule photosensible du capteur n'est pas constant sur toute la gamme dynamique de tension du capteur, le dispositif de conversion analogique-numérique doit être configuré pour tenir compte de la différence de bruit entre une faible illumination et une forte illumination des pixels. La figure 3 représente un graphique montrant la variation du bruit en fonction du niveau de tension produit par chaque pixel dans la gamme dynamique de tension du capteur en fonction du niveau d'illumination des pixels. Pour un capteur d'image du type APS VGA réalisé en technologie CMOS, on remarque que le bruit à faible illumination, proche de la valeur de tension basse de la gamme dynamique, vaut environ 1 mV, alors que le bruit à forte illumination, proche de la valeur de tension haute de la gamme dynamique, vaut environ 8 mV. De ce fait, le dispositif de conversion doit pouvoir convertir plus finement des pixels faiblement éclairés que des pixels plus fortement éclairés par une amplification numérique adaptée. L'amplification de conversion des pixels faiblement éclairés du dispositif doit donc être 8 fois plus importante dans une zone faiblement éclairée des pixels que dans une zone fortement éclairée.

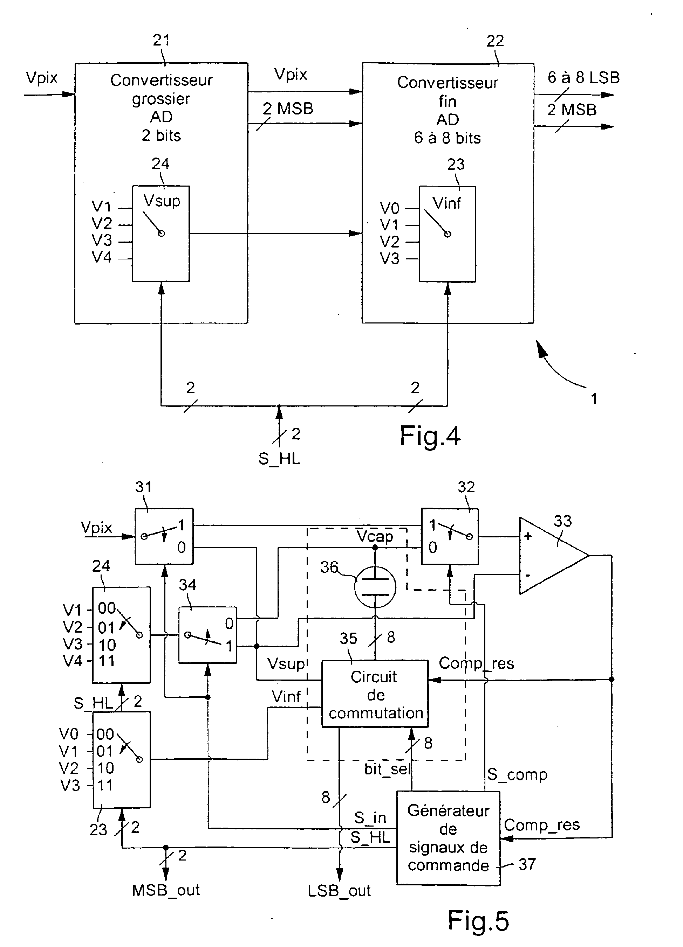

Le dispositif de conversion analogique-numérique surnuméraire, objet de l'invention, est représenté de manière schématique à la figure 4. Ce dispositif comprend essentiellement au moins un premier convertisseur grossier non linéaire 21 et au moins un second convertisseur fin linéaire 22 pour convertir un signal de tension Vpix fourni par un pixel. Le premier convertisseur 21 fournit un mot binaire à N bits de poids fort, par exemple 2 bits, alors que le second convertisseur fournit un mot binaire à M bits de poids faible, par exemple 8 bits. De cette manière, le dispositif fournit un mot binaire à N+M bits, par exemple 10 bits correspondant au signal de tension converti Vpix de chaque pixel.

Dans une première étape de conversion, le premier convertisseur 21 reçoit la tension convertie Vpix de chaque pixel. Ce premier convertisseur 21 a pour tâche de situer le niveau de tension du pixel dans une des plages de tension déterminées de la gamme dynamique de tension du capteur d'image. Cette gamme dynamique est divisée donc en plusieurs plages de tension successives délimitées entre les valeurs inférieure V0 et supérieure V4 de tension de la gamme dynamique par des seuils de tension V1 à V3. Etant donné que dans ce mode de réalisation il est prévu trois seuils de tension, quatre plages de tension définissent chacune une zone particulière d'illumination de chaque pixel entre une zone faiblement éclairée et une zone fortement éclairée.

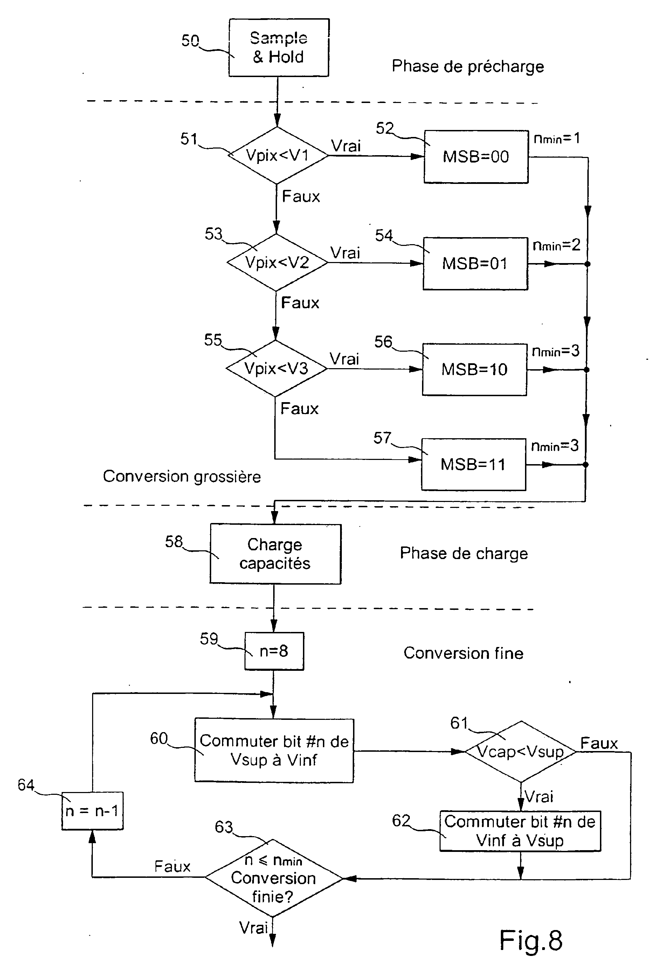

Le premier convertisseur comprend des moyens de comparaison non représentés pour comparer le niveau de tension du pixel avec des seuils de tension V1 à V3 fournis successivement par un multiplexeur 24 de tension supérieure de référence Vsup de manière à déterminer la plage de tension de chaque pixel. Pour ce faire, le multiplexeur 24, qui reçoit en entrée les trois seuils de tension V1 à V3, ainsi que la tension haute de la gamme dynamique V4, est commandé par un signal de commande S_HL à 2 bits. Ce signal de commande peut être incrémenté d'une première valeur binaire égale à 00 à une quatrième valeur binaire égale à 11, comme il sera expliqué ci-après en référence à la figure 8. Avec la première valeur du signal de commande S_HL, le premier seuil de tension V1 est comparé à la tension Vpix. Si cette tension Vpix est supérieure au premier seuil de tension V1, le signal de commande est incrémenté d'une unité afin de comparer le second seuil de tension V2 avec la tension Vpix. Si cette tension Vpix est supérieure au second seuil de tension V2 le signal est à nouveau incrémenté d'une ou deux unités jusqu'à ce que la tension Vpix soit bien localisée par rapport à la gamme dynamique.

Bien entendu, les valeurs du signal de commande S_HL indiquées ci-dessus sont données à titre d'exemple car elles peuvent être agencées différemment pour sélectionner un des seuils de tension à comparer avec la tension Vpix.

Une fois que la tension Vpix a été située dans une des zones d'illumination, le mot binaire à 2 bits de poids fort fourni par le premier convertisseur est défini par la valeur du signal de commande S_HL. Ce mot binaire à 2 bits permet de configurer le second convertisseur 22 pour qu'il travaille dans la plage de tension sélectionnée où se trouve la tension Vpix.

Le second convertisseur 22 comprend notamment un multiplexeur 23 de tension inférieure Vinf, qui reçoit en entrée la tension basse V0 de la gamme dynamique et les trois seuils de tension V1 à V3. Ce multiplexeur est commandé par le même signal de commande S_HL de manière à fournir en sortie la tension inférieure Vinf. Ainsi en fonction du mot binaire du premier convertisseur relatif à la valeur du signal de commande S_HL, le second convertisseur est configuré pour opérer entre la tension supérieure fournie par le multiplexeur 24 et la tension inférieure fournie par le multiplexeur 23. En fonction de ces tensions inférieure et supérieure de la plage de tension sélectionnée, des moyens d'adaptation de conversion du second convertisseur permettent à ce dernier de convertir le signal de tension du pixel sur un nombre de bits inférieur ou égal à M. Comme le second convertisseur 22 fournit un mot binaire à 8 bits LSB, les moyens d'adaptation permettent au second convertisseur d'opérer une conversion sur 8 bits pour une première zone de faible illumination, sur 7 bits pour une seconde zone de moyenne illumination et sur 6 bits pour des troisième et quatrième zones de forte illumination. Les bits non convertis par le second convertisseur sont définis arbitrairement de manière à ce que le dispositif 1 fournisse un mot binaire à 10 bits.

Comme pour une zone faiblement éclairée, il est nécessaire que le second convertisseur convertisse plus finement qu'en moyenne ou en forte illumination, la taille des plages de tension varie. Cette variation de taille des plages de tension permet de modifier le gain de conversion. Cette taille est plus petite pour une zone faiblement éclairée que pour une zone fortement éclairée afin de tenir compte de la différence de bruit entre ces deux zones.

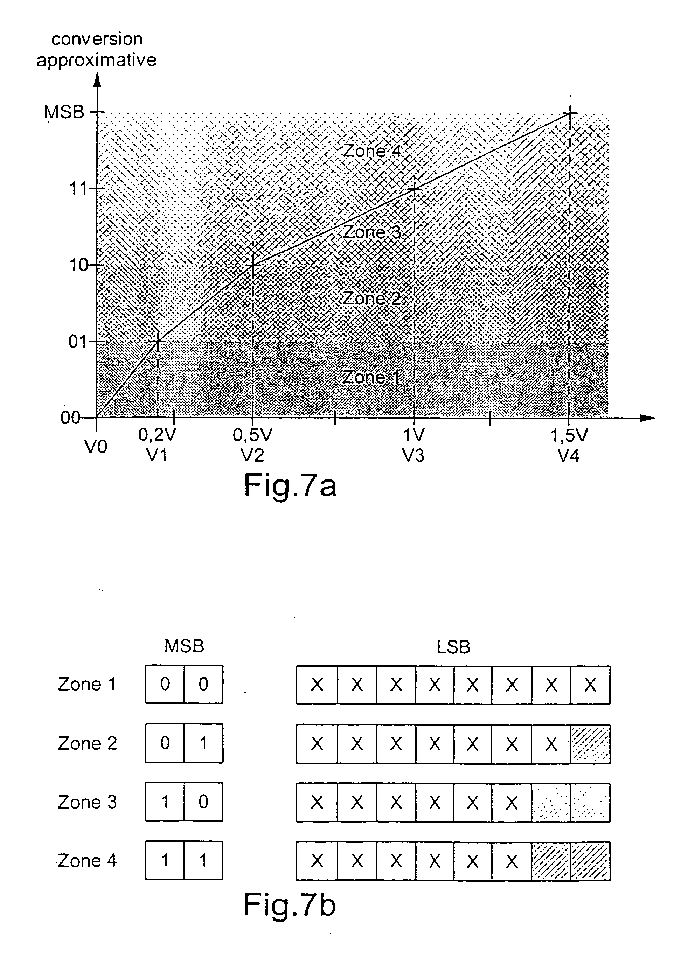

Comme montré à la figure 7a, la taille de la première plage de tension de la gamme dynamique, correspondant à la première zone d'illumination Zone 1 des pixels faiblement éclairés, est proche de 0,2 V. La taille de la seconde plage de tension, correspondant à la seconde zone d'illumination Zone 2 des pixels moyennement éclairés, est d'environ 0,3 V. Finalement, la taille des troisième et quatrième plages de tension, correspondant aux troisième et quatrième zones d'illumination Zone 3 et Zone 4 des pixels fortement éclairés, est de 0,5 V chacune. Chaque zone d'illumination correspond à un mot binaire différent fourni par le premier convertisseur.

A ce titre pour les plages de tension, on peut définir un gain de conversion ou une sensibilité par bit de conversion par les formules suivantes :

$$\text{gain} : A_{conv} = (2^n)/\Delta V_{zone} \qquad \text{sensibilité} : S_{conv} = \Delta V_{zone}/(2^n) \ [mV]$$

où $\Delta V_{zone}$ est la taille de la plage de tension correspondante et n définit le nombre de bits de conversion du second convertisseur. Pour une conversion dans la première plage de tension, la sensibilité par bit de conversion est proche de 0,8 mV, car le second convertisseur opère une conversion sur 8 bits. Grâce à la taille adaptée de cette première plage de tension, la précision de conversion peut être considérée équivalente à celle d'un convertisseur linéaire à 11 bits opérant sur toute la gamme dynamique. Pour une conversion dans la seconde plage de tension, la sensibilité par bit de conversion est légèrement supérieure à 2 mV, car le second convertisseur n'opère une conversion que sur 7 bits. Finalement, pour une conversion dans les troisième et quatrième plages de tension, la sensibilité par bit de conversion est proche de 7,8 mV, car le second convertisseur n'opère une conversion que sur 6 bits.

Ainsi, avec ces tailles différentes des plages de tension, il est possible de réaliser une amplification 8 fois plus importante pour les signaux de tension des pixels faiblement éclairés par rapport aux signaux des pixels fortement éclairés. De ce fait, le dispositif de conversion analogique-numérique surnuméraire est configuré pour éviter de convertir inutilement du bruit et effectuer une conversion avec un nombre minimum d'étapes.

A la figure 7b, il est représenté un registre à 10 bits pour chaque mot binaire de pixels qui se trouvent soit dans la zone 1, dans la zone 2, dans la zone 3 ou dans la zone 4. Les deux bits de poids fort MSB sont calculés par le premier convertisseur pour situer chaque pixel dans une des plages de tension déterminée, alors que les 8 bits de poids faible LSB sont définis par le second convertisseur. Dans la zone 1, le second convertisseur convertit le signal de tension du pixel faiblement éclairé sur 8 bits. Dans la zone 2, le second convertisseur ne convertit le signal de tension du pixel moyennement éclairé que sur 7 bits sans convertir le dernier bit de poids faible qui est noyé dans le bruit et ne représente donc aucune information. Dans les zones 3 et 4, le second convertisseur ne convertit le signal de tension du pixel fortement éclairé que sur 6 bits sans convertir les deux derniers bits de poids faible ne correspondant qu'à du bruit.

De manière plus détaillée, la figure 5 montre les composants du dispositif de conversion analogique-numérique surnuméraire combinant les premier et second convertisseurs. Comme expliqué également ci-dessous en référence à la figure 8 relative au procédé de conversion, le premier convertisseur doit situer, dans une première phase et de manière successive, la tension du pixel Vpix dans une des plages de tension. Pour ce faire, le dé-multiplexeur 31 est commandé par un signal de commande S_in de manière à fournir en sortie désignée 1 le signal de tension Vpix. Ce signal de commande S_in est produit par un générateur de signaux de commande 37. Le multiplexeur 32 reçoit à l'entrée désignée 1 la tension Vpix. En fonction de l'état d'un signal de commande S_comp produit par le générateur de signaux de commande 37, ce multiplexeur 32 relie la tension Vpix à l'entrée positive d'un unique comparateur 33 représentant les moyens de comparaison.

Dans cette première phase, une comparaison doit être réalisée entre la tension Vpix et un des seuils de tensions V1 à V3 fourni par le multiplexeur 24 de tension supérieure. Le seuil de tension sélectionné par le signal de commande S_HL décrit précédemment passe par un dé-multiplexeur 34 qui est commandé également par le signal de commande S_in pour fournir en sortie désignée 1 le seuil de tension sélectionné. Initialement, le premier seuil de tension est sélectionné pour être relié à l'entrée négative du comparateur 33. Si la tension Vpix est supérieure à ce premier seuil de tension V1, le signal de sortie Comp_res du comparateur va commander le générateur de signaux 37 pour qu'il incrémente d'une unité le signal de commande S_HL. Ainsi, une comparaison entre la tension Vpix et un seuil de tension déterminé va se poursuivre jusqu'à pouvoir situer la tension Vpix dans une des plages de tension de la gamme dynamique. Si à la fin de l'étape de comparaison, le signal de commande S_HL vaut 00 en binaire, la tension Vpix est dans la première plage de tension. Si le signal S_HL vaut 01 en binaire, la tension Vpix est dans la seconde plage de tension. Si le signal S_HL vaut 10 en binaire, la tension Vpix est dans la troisième plage de tension. Finalement, si le signal S_HL vaut 11 en binaire, la tension Vpix est dans la quatrième plage de tension.

Après que les deux bits de poids fort MSB ont été déterminés, le second convertisseur doit pouvoir opérer une conversion fine en fonction de la plage de tension déterminée. Pour ce faire, le second convertisseur comprend notamment un circuit de commutation 35 ayant des moyens d'adaptation de conversion selon la plage de tension déterminée et un réseau à capacités commutées 36, qui sont montrés à l'intérieur du cadre en traits interrompus.

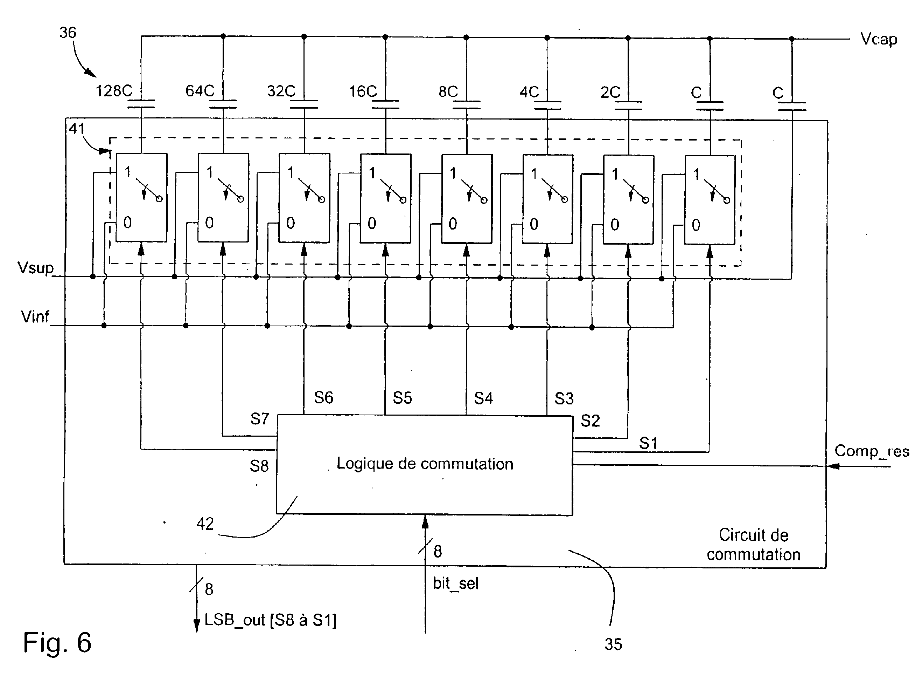

Pour les opérations de conversion, le circuit de commutation 35 reçoit notamment une tension haute Vsup fournie par le multiplexeur 24 et une tension basse Vinf fournie par le multiplexeur 23 selon la plage de tension déterminée. Le circuit de commutation, qui est expliqué ci-dessous de manière plus détaillée en référence à la figure 6, commande la connexion successive de 8 capacités de valeurs pondérées par puissance de 2 à la tension inférieure Vinf ou à la tension supérieure Vsup en fonction du niveau de la tension du pixel Vpix.

Une borne Vcap du réseau à capacités commutées 36 est commune à toutes les capacités du réseau. Cette borne Vcap est reliée à la borne positive du comparateur 33 lorsque l'entrée désignée 0 du multiplexeur 32 est sélectionnée par le signal de commande S_comp. De cette manière, le comparateur 33 du premier convertisseur peut avantageusement être réutilisé dans les opérations de conversion du second convertisseur.

La conversion fine commence par une phase de charge où la borne Vcap est tout d'abord reliée à la tension haute fournie par le multiplexeur 24 lorsque la sortie désignée 0 est sélectionnée par le signal de commande S_in. Ce signal de commande S_in permet également au dé-multiplexeur 31 de fournir à sa sortie désignée 0, la tension du pixel Vpix. Cette tension du pixel Vpix remplace dans la phase de charge du réseau de capacités la tension Vsup à l'entrée du circuit de commutation 35.

Après cette étape de charge, la borne Vcap est laissée flottante et est décalée d'une tension équivalente à la tension du pixel Vpix lorsque le dé-multiplexeur 34 est commuté sur la sortie désignée 1. De cette manière à l'aide d'un signal de sélection à 8 bits bit_sel fourni par le générateur de signaux de commande 37, l'opération de conversion fine par le second convertisseur peut être réalisée. Les capacités du réseau 36 sont connectées successivement à la tension inférieure Vinf, puis reconnectée à la tension supérieure Vsup en fonction du signal de sortie Comp_res du comparateur 33. Comme cette opération de conversion à l'aide d'un réseau à capacités commutées est bien connue, il n'est décrit que sommairement les éléments constituant ce second convertisseur.

La figure 6 montre de manière plus détaillée les principaux composants du second convertisseur. Le circuit de commutation 35 comprend une logique de commutation 42 pour commander un groupe de multiplexeurs 41, montré dans un cadre en traits interrompus. La sortie de chaque multiplexeur du groupe de multiplexeurs 41 est reliée à une des huit capacités du réseau commuté 36. La valeur de chaque capacité est dépendante de la position de chaque bit de conversion dans un mot binaire déterminé par le second convertisseur, c'est-à-dire dépendante d'une puissance de 2. De ce fait, les valeurs des capacités sont définies du bit le plus faible au bit le plus fort de la valeur C à la valeur 128C. Une capacité supplémentaire C doit être prévue dans le second convertisseur, dont une borne est reliée au noeud flottant Vcap et l'autre borne doit être reliée à un potentiel fixe quelconque par exemple à Vsup.

Une entrée désignée 1 des multiplexeurs est reliée à la tension supérieure Vsup, alors qu'une entrée désignée 0 est reliée à la tension inférieure Vinf de la plage de tension déterminée. Dans cette logique de commutation, qui reçoit le signal de sélection à 8 bits bit_sel et le signal de sortie Comp_res du comparateur, des signaux de commutation S1 à S8 sont déterminés afin de commander successivement chacun un multiplexeur correspondant du groupe de multiplexeurs 41. Cette logique de commutation 35 va commuter successivement chaque capacité à la tension inférieure Vinf, puis la rétablir à la tension supérieure Vsup en fonction du signal Comp_res de la comparaison. Cette opération s'effectue en partant de la capacité de plus grande valeur à la capacité la plus faible.

Suivant la plage de tension déterminée, le circuit de commutation avec la logique de commutation est configuré pour exécuter des opérations de conversion sur 8 bits en cas de faible illumination, sur 7 bits en cas de moyenne illumination ou sur 6 bits en cas de forte illumination. A la fin de la seconde conversion, l'état des signaux de commutation S1 à S8 vont servir à fournir le mot binaire à 8 bits LSB_out qui est placé dans un registre du dispositif en tant que bits de poids faible. Bien entendu, selon la zone d'illumination déterminée, le ou les deux derniers bits de ce mot binaire sont définis arbitrairement.

Les étapes du procédé de conversion analogique-numérique vont être décrites ci-dessous en référence à la figure 8. Le tableau suivant montre l'état des différents signaux de commande représentés à la figure 5 qui sont appliqués aux multiplexeurs respectifs selon les différentes étapes du procédé :

| PHASES | S_in | S_comp | S_HL |
|---|---|---|---|
| Pré-charge | 1 | 1 | 00 |
| 1ère conversion | 1 | 1 | 00, 01, 10, 11 |
| Charge | 0 | 0 | Sélection |
| 2e conversion | 1 | 0 | Sélection |

La première étape 50 du procédé de conversion analogique-numérique est relative à une phase de pré-charge dans laquelle le pixel fournit une tension relative à son illumination au dispositif de conversion analogique-numérique. Dès le moment où le dispositif de conversion reçoit une valeur stable de la tension du pixel, le premier convertisseur est mis en fonction pour opérer une conversion grossière.

A l'étape 51, la tension du pixel Vpix est comparée au premier seuil de tension V1. Si cette tension Vpix est inférieure au seuil V1, alors le pixel est faiblement éclairé et la première plage de tension de la gamme dynamique est sélectionnée par le mot binaire à 2 bits de poids fort MSB valant 00 à l'étape 52. Par contre si cette tension Vpix est supérieure à V1, alors le signal S_HL est incrémenté d'une unité afin de permettre la comparaison de la tension Vpix avec le second seuil de tension V2 à l'étape 53. Si la tension Vpix est inférieure au seuil V2, alors la seconde plage de tension de la gamme dynamique est sélectionnée par le mot binaire à 2 bits de poids fort MSB valant 01 à l'étape 54. Par contre si cette tension Vpix est supérieure à V2, alors le signal S_HL est incrémenté d'une unité afin de permettre la comparaison de la tension Vpix avec le troisième seuil de tension V3 à l'étape 55. Si la tension Vpix est inférieure au seuil V3, alors la troisième plage de tension de la gamme dynamique est sélectionnée par le mot binaire à 2 bits de poids fort MSB valant 10 à l'étape 56. Par contre si cette tension Vpix est supérieure au troisième seuil de tension V3, alors le pixel se trouve dans la zone de plus forte illumination. Le signal S_HL est ainsi incrémenté d'une unité afin que la quatrième plage de tension de la gamme dynamique soit sélectionnée par le mot binaire à 2 bits de poids fort MSB valant 11 à l'étape 57.

En relation avec le mot binaire à 2 bits fourni par le premier convertisseur, un nombre minimal $n_{min}$ est défini pour arrêter le second convertisseur avant qu'il ne convertisse du bruit.

Avant d'entreprendre les étapes de la conversion fine, une phase de charge des condensateurs du réseau à capacités commutées est réalisée à l'étape 58 de manière à échantillonner la tension Vpix. Comme on peut le voir par le tableau ci-dessus dans cette phase de charge à l'étape 58, les signaux S_in et S_comp sont à l'état 0. Ceci signifie que la borne commune des capacités Vcap reçoit la tension haute de la plage de tension déterminée, alors que le circuit de commutation et la borne négative du comparateur reçoivent la tension du pixel en lieu et place de la tension haute. Le réseau de capacités est alors chargé à Vsup-Vpix.

Après avoir chargé cette borne commune des capacités, le signal de commande S_in passe à l'état 1 ce qui laisse cette borne commune flottante. Le circuit de commutation reçoit à nouveau la tension haute Vsup de la plage de tension déterminée. Ceci a pour conséquence d'élever le niveau de tension de la borne commune des capacités de la tension Vsup, on a alors la tension Vcap=(2Vsup-Vpix).

Pour la conversion fine réalisée par le second convertisseur, le nombre n de bits de conversion est fixé à 8 à l'étape 59. A l'étape 60 dans le circuit de commutation, le multiplexeur de la capacité représentant le bit numéro 8 (128C) est commuté de la tension Vsup à la tension Vinf. Un contrôle de la tension Vcap est effectué à l'étape 61 afin de savoir si cette tension Vcap est passée en dessous de la tension Vsup. Dans l'affirmative, le multiplexeur de la capacité représentant le bit numéro 8 est commuté de la tension Vinf à la tension Vsup à l'étape 62, avant d'opérer le contrôle de fin de conversion à l'étape 63. Par contre si la tension Vcap est supérieure à la tension Vsup à l'étape 61, le multiplexeur reste en l'état. Si le nombre n est inférieur ou égal au nombre minimal $n_{min}$, la conversion fine est terminée. Dans le cas contraire, le nombre n est décrémenté d'une unité et les étapes 60 à 63 sont exécutées relatives à la connexion de la capacité représentant le bit numéro 7 (64C). Toutes les étapes 60 à 64 sont effectuées successivement pour la connexion des autres capacités à la tension Vinf ou à la tension Vsup jusqu'à ce que n soit inférieur ou égal à $n_{min}$.

Au terme de la conversion fine, le second convertisseur fournit un mot binaire à 8 bits de poids faible, après avoir effectué une conversion de 6 à 8 bits en fonction de la plage de tension déterminée du pixel. Le ou les bits de poids faible non convertis par le second convertisseur sont fixés de manière arbitraire. Avec ce procédé de conversion analogique-numérique, il est à noter que le nombre de comparaisons effectuées par le comparateur, soit le total de la conversion grossière et de la conversion fine, est toujours identique, indépendamment de l'illumination du pixel. Grâce au procédé de mise en action du dispositif de conversion analogique-numérique, il est effectué 9 comparaisons pour n'importe quelle zone d'illumination du pixel. Ainsi, le dispositif de conversion permet de fournir une précision suffisante à faible illumination tout en évitant de convertir inutilement du bruit à moyenne ou forte illumination.

A partir de la description qui vient d'être faite de multiples variantes de réalisation du dispositif et du procédé de conversion analogique-numérique peuvent être conçues par l'homme du métier sans sortir du cadre de l'invention définie par les revendications. Dans le cas d'un dispositif fournissant un mot binaire à 10 bits, il peut être prévu par exemple que le premier convertisseur fournisse un mot binaire à 1 bit, à 3 bits ou 4 bits, alors que le second convertisseur fournit un mot binaire à 9 bits, 7 bits ou à 6 bits. Bien entendu, le nombre de zones d'illumination est dépendant du nombre de bits fourni par le premier convertisseur. En lieu et place d'un unique comparateur, il peut être prévu que les moyens de comparaison comprennent plusieurs comparateurs placés en parallèle pour comparer en même temps chaque seuil de tension avec la tension du pixel.

## Revendications

1. Dispositif de conversion analogique-numérique (1) notamment pour un capteur d'image (11) qui comprend une cellule photosensible à matrice de pixels (2) pour capter une image à numériser, le dispositif comprenant au moins un premier convertisseur à N bits (21) et au moins un second convertisseur à M bits (22) connecté au premier convertisseur, les premier et second convertisseurs permettant de convertir un niveau de tension ou de courant d'un signal de tension (Vpix) ou de courant provenant d'un pixel sur N+M bits, le niveau de tension ou de courant à convertir étant dépendant d'un niveau de lumière captée par le pixel dans une gamme dynamique (Vdyn) déterminée de tension ou de courant du capteur, le premier convertisseur comprenant des moyens de comparaison (33) pour comparer le niveau de tension ou de courant du pixel avec un ou plusieurs seuils de tension (V0 à V4) ou de courant qui délimitent des plages successives de tension ou de courant dans la gamme dynamique afin de fournir un mot binaire à N bits de poids fort dont la valeur est relative à la plage de tension ou de courant où se situe le niveau de tension ou de courant du pixel, les plages successives de tension ou de courant dans la gamme dynamique permettant de définir l'illumination d'un pixel allant d'un pixel faiblement illuminé à un pixel fortement illuminé, **caractérisé en ce que** le second convertisseur comprend des moyens d'adaptation de conversion (35) qui sont configurés par la plage de tension ou de courant déterminée entre une tension minimale ou un courant minimal et une tension maximale ou un courant maximal de ladite plage de tension ou de courant en fonction de la valeur du mot binaire à N bits de poids fort fourni par le premier convertisseur, les moyens d'adaptation de conversion étant configurés pour effectuer une conversion du signal de tension ou de courant du pixel sur un nombre de bits de poids faible inférieur à M sans convertir le ou les derniers bits de poids le plus faible pour une plage de tension ou de courant déterminée d'un pixel fortement illuminé ou égal à M pour une plage de tension ou de courant déterminée d'un pixel qui est faiblement illuminé.

2. Dispositif de conversion selon la revendication 1, **caractérisé en ce qu'**il comprend un registre dans lequel sont placés les N bits de poids fort du premier convertisseur non linéaire et les M bits de poids faible du second convertisseur linéaire.

3. Dispositif de conversion selon l'une des revendications précédentes, **caractérisé en ce que** le premier convertisseur fournit un mot binaire à 2 bits de poids fort dont la valeur représente une des 4 plages de tension de la gamme dynamique de tension, et **en ce que** les moyens d'adaptation de conversion du second convertisseur permettent au second convertisseur d'effectuer une conversion sur 8 bits dans le cas où le niveau de tension du pixel se trouve dans une première plage de tension d'un pixel faiblement illuminé, une conversion sur 7 bits dans le cas où le niveau de tension du pixel se trouve dans une deuxième plage de tension d'un pixel moyennement illuminé, et une conversion sur 6 bits dans le cas où le niveau de tension du pixel se trouve dans des troisième ou quatrième plages de tension d'un pixel fortement illuminé, les bits de poids faible non convertis par le second convertisseur étant définis arbitrairement de manière que les premier et second convertisseurs fournissent un mot binaire à 10 bits.

4. Dispositif de conversion selon l'une des revendications précédentes, **caractérisé en ce qu'**il est configuré pour que la taille de chaque plage de tension ou de courant de la gamme dynamique soit dépendante de la sensibilité du capteur, la taille de la plage de tension d'un pixel faiblement illuminé étant plus petite que la taille de la plage de tension d'un pixel moyennement ou fortement illuminé de manière à augmenter la sensibilité du second convertisseur pour les opérations de conversion fine, de telle manière que le convertisseur possède une sensibilité adaptée à celle du capteur.

5. Dispositif de conversion selon la revendication 4, **caractérisé en ce que** la taille de la première plage de tension d'un pixel faiblement illuminé est définie de telle manière que la sensibilité par bit de conversion du second convertisseur corresponde à une sensibilité par bit équivalente d'un convertisseur linéaire traditionnel à N+M+k bits, notamment d'un convertisseur à 11 bits sur toute la gamme dynamique de tension ou de courant, et **en ce que** la taille de la dernière plage de tension d'un pixel fortement illuminé est définie de telle manière que la sensibilité par bit de conversion du second convertisseur corresponde à une sensibilité par bit sensiblement équivalente d'un convertisseur linéaire traditionnel à N+M-I bits, notamment d'un convertisseur à 8 bits sur toute la gamme dynamique de tension ou de courant pour tenir compte d'un facteur de bruit $2^{k-l}$ fois, notamment 8 fois plus fort d'un pixel fortement illuminé par rapport à un pixel faiblement illuminé.

6. Dispositif de conversion selon la revendication 1, **caractérisé en ce que** le premier convertisseur comprend un dé-multiplexeur (31) commandé par un premier signal de commande (S_in) fourni par un générateur de signaux de commande pour relier le signal de tension (Vpix) ou de courant d'un pixel à une première entrée des moyens de comparaison, tel qu'un comparateur (33), ou à une première entrée d'un circuit de commutation (35) du second convertisseur dans une phase de charge, un premier multiplexeur (24) recevant en entrée les seuils de tension ou de courant délimitant les plages de tension ou de courant et la valeur limite haute de tension ou de courant de la gamme dynamique, le premier multiplexeur étant commandé par un second signal de commande (S_HL) fourni par ledit générateur de signaux de commande (37) pour connecter un des seuils de tension ou de courant à une seconde entrée du comparateur, la sortie du comparateur étant connectée au générateur de signaux de commande pour modifier ou conserver l'état du second signal de commande en fonction du résultat de la comparaison entre le signal de tension ou de courant du pixel avec un des niveaux seuils de tension ou de courant.

7. Dispositif de conversion selon la revendication 6, **caractérisé en ce que** le second convertisseur comprend un réseau à capacités commutées (36), le circuit de commutation (35) pour commander la connexion de capacités dudit réseau, et un second multiplexeur (23) commandé par le second signal de commande (S_HL) fourni par ledit générateur de signaux de commande (37), ledit second multiplexeur recevant en entrée la valeur limite basse de tension ou de courant de la gamme dynamique, et les seuils de tension ou de courant pour fournir une tension inférieure ou un courant inférieur de la plage de tension ou de courant déterminée à une seconde entrée du circuit de commutation dépendant du mot binaire fourni par le premier convertisseur, le mot binaire étant défini par l'état du second signal de commande à N bits, de préférence à 2 bits, la première entrée du circuit de commutation recevant une tension supérieure ou un courant supérieur de la plage de tension ou de courant déterminée fournie par le premier multiplexeur.

8. Dispositif de conversion selon la revendication 7, **caractérisé en ce que** le second convertisseur comprend un troisième multiplexeur (32) relié entre le dé-multiplexeur et le comparateur, le troisième multiplexeur étant commandé par un troisième signal de commande (S_comp) fourni par le générateur de signaux de commande de manière à connecter une borne du réseau à capacités commutées au comparateur du premier convertisseur dans une phase de conversion du second convertisseur, et **en ce que** le second convertisseur opère entre les tensions inférieure et supérieure de la plage de tension déterminée par le mot binaire fourni par le premier convertisseur pour convertir le niveau de tension ou de courant sur un nombre de bits inférieur ou égal à M.

9. Capteur d'image comprenant une cellule photosensible à matrice de pixels (2) pour capter une image à numériser, au moins un dispositif de conversion analogique-numérique selon l'une des revendications précédentes, un moyenneur d'illumination (5) relié en sortie du dispositif, et un adaptateur d'échelle (4) relié en sortie du dispositif et recevant un signal de commande du moyenneur, **caractérisé en ce que** le dispositif comprend plusieurs premier et second convertisseurs placés en parallèle de manière à convertir chacun sur N+M bits un signal de tension ou de courant fourni par un pixel correspondant, et **en ce que** le moyenneur reçoit le résultat de la conversion du niveau de tension ou de courant de chaque pixel pour fournir un signal de commande à l'adaptateur afin qu'il fournisse en sortie un mot binaire à K bits sélectionnés dans chaque mot binaire à N+M bits fournis par le dispositif en fonction d'une moyenne d'illumination déterminée par ledit moyenneur.

10. Capteur d'image selon la revendication 9, **caractérisé en ce que** le dispositif de conversion fournit un mot binaire à 10 bits relatif au niveau de tension ou de courant de chaque pixel, et **en ce que** l'adaptateur d'échelle sélectionne 8 bits successifs de chaque mot binaire à 10 bits en fonction de la moyenne d'illumination déterminée par ledit moyenneur.

**11.** Procédé de conversion analogique-numérique, notamment d'un capteur d'image (11) qui comprend une cellule photosensible à matrice de pixels (2) pour capter une image à numériser, pour la mise en action du dispositif de conversion selon l'une des revendications 1 à 8, **caractérisé en ce qu'**il comprend une série d'étapes consistant à :

- comparer dans le premier convertisseur le niveau de tension ou de courant du pixel avec au moins un seuil de tension ou de courant de la gamme dynamique délimitant des plages successives de tension ou de courant,
- fournir un mot binaire à N bits de poids fort dont la valeur est relative à la plage de tension ou de courant où se situe le niveau de tension ou de courant du pixel, les plages successives de tension ou de courant dans la gamme dynamique permettant de définir l'illumination d'un pixel allant d'un pixel faiblement illuminé à un pixel fortement illuminé
- configurer le second convertisseur par la plage de tension ou de courant déterminée entre une tension minimale ou un courant minimal et une tension maximale ou un courant maximal de ladite plage de tension ou de courant en fonction de la valeur du mot binaire à N bits de poids fort fourni par le premier convertisseur, et
- convertir dans le second convertisseur le niveau de tension ou de courant du pixel sur un nombre de bits de poids faible inférieur à M sans convertir le ou les derniers bits de poids le plus faible pour une plage de tension ou de courant déterminée d'un pixel moyennement ou fortement illuminé ou égal à M pour une plage de tension ou de courant déterminée d'un pixel qui est faiblement illuminé.

**12.** Procédé de conversion selon la revendication 11, **caractérisé en ce que** le premier convertisseur fournit un mot binaire à 2 bits de poids fort dont la valeur représente une des 4 plages de tension de la gamme dynamique de tension, la taille de la première plage de tension d'un pixel faiblement illuminé étant plus petite que la taille des plages de tension d'un pixel moyennement ou fortement illuminé, et **en ce que** le second convertisseur exécute une conversion sur 8 bits dans le cas où le niveau de tension du pixel se trouve dans une première plage de tension d'un pixel faiblement illuminé, une conversion sur 7 bits dans le cas où le niveau de tension du pixel se trouve dans une deuxième plage de tension d'un pixel moyennement illuminé, et une conversion sur 6 bits dans le cas où le niveau de tension du pixel se trouve dans des troisième ou quatrième plages de tension d'un pixel fortement illuminé, les bits de poids faible non convertis par le second convertisseur étant définis arbitrairement pour que le dispositif fournisse un mot binaire à 10 bits.

**13.** Procédé de conversion selon la revendication 11, **caractérisé en ce que** les premier et second convertisseurs effectuent la conversion analogique-numérique de manière successive pour n'utiliser qu'un unique comparateur pour les étapes de comparaison des deux convertisseurs avec les seuils de tension ou de courant de la gamme dynamique.

**Claims**

**1.** Analog-digital conversion device (1) in particular for an image sensor (11) that comprises a pixel matrix photosensitive cell (2) to pick up an image to be digitised, the device comprising at least one N-bit first converter (21) and at least one M-bit second converter (22) connected to the first converter, the first and second converters being used to convert a voltage or current level of a voltage or current pixel signal (Vpix) to N + M bits, the voltage or current level to be converted depending on the level of light captured by the pixel in a particular voltage or current dynamic range (Vdyn) of the sensor, the first converter comprising comparison means (33) for comparing the voltage or current level of the pixel with one or more voltage or current thresholds (V0 to V4) delimiting successive voltage or current ranges within the dynamic range in order to supply an N-bit binary word of more significant bits whose value relates to the voltage or current range in which the voltage or current level of the pixel is situated, the successive voltage or current ranges within the dynamic range being used to define the illumination of a pixel, ranging from a weakly illuminated pixel to a strongly illuminated pixel, **characterized in that** the second converter comprises conversion adaptation means (35) that are configured for the voltage or current range that has been determined between a minimum voltage or current and a maximum voltage or current of said voltage or current range as a function of the value of the N-bit binary word of more significant bits supplied by the first converter, the conversion adaptation means being configured to convert the voltage or current pixel signal to a number of less significant bits less than M without converting one or the last bits, which are the lowest, for a voltage or current range that has been determined corresponding to a strongly-illuminated pixel or equal to M for a voltage or current range that has been determined corresponding to a pixel that is not strongly illuminated.

2. Conversion device according to claim 1, **characterized in that** it comprises a register in which are placed the N more significant bits from the nonlinear first converter and the M less significant bits from the linear second converter.

3. Conversion device according to any of the preceding claims, **characterized in that** the first converter supplies a binary word comprising two more significant bits whose value represents one of the four voltage ranges of the voltage dynamic range and **in that** the conversion adaptation means of the second converter enable the second converter to effect conversion on 8 bits if the voltage level of the pixel is in a first voltage range corresponding to a weakly illuminated pixel, conversion on 7 bits if the voltage level of the pixel is in a second voltage range corresponding to a moderately illuminated pixel, or conversion on 6 bits if the voltage level of the pixel is in third or fourth voltage ranges corresponding to a strongly illuminated pixel, the less significant bits not converted by the second converter being defined arbitrarily so that the first and second converters supply a 10-bit binary word.

4. Conversion device according to any of the preceding claims, **characterized in that** it is configured so that the size of each voltage or current range of the dynamic range depends on the sensitivity of the sensor, the size of the voltage or current range corresponding to a weakly illuminated pixel being smaller than the size of the voltage or current range corresponding to a moderately or strongly illuminated pixel so as to increase the sensitivity of the second converter for the conversion operations in a manner such that the converter has a sensitivity adapted to that of the sensor.

5. Conversion device according to claim 4, **characterized in that** the size of the first voltage range corresponding to a weakly illuminated pixel is defined so that the sensitivity per conversion bit of the second converter corresponds to an equivalent sensitivity per bit of a conventional linear converter of N + M + k bits, in particular an 11-bit converter, over the whole of the voltage or current dynamic range, and **in that** the size of the last voltage range corresponding to a strongly illuminated pixel is defined so that the sensitivity per conversion bit of the second converter corresponds to a substantially equivalent sensitivity per bit of a conventional linear converter of N + M - I bits, in particular an 8-bit converter, over the whole of the voltage or current dynamic range, to take account of a noise factor $2^{k-l}$ times, in particular 8 times higher for a strongly illuminated pixel compared to a weakly illuminated pixel.

6. Conversion device according to claim 1, **characterized in that** the first converter comprises a demultiplexer (31) controlled by a first control signal (S_in) supplied by a control signal generator to connect the voltage or current signal (Vpix) of a pixel to a first input of the comparison means, such as a comparator (33), or to a first input of a switching circuit (35) of the second converter during a charging phase, a first multiplexer (24) receiving at its input the voltage or current thresholds delimiting the voltage or current ranges and the upper limit voltage or current value of the dynamic range, the first multiplexer being controlled by a second control signal (S_HL) supplied by said control signal generator (37) to connect one of he voltage or current thresholds to a second input of the comparator, and the output of the comparator being connected to the control signal generator to modify or maintain the state of the second control signal as a function of the result of comparing the voltage or current signal of the pixel with one of the voltage or current thresholds.

7. Conversion device according to claim 6, **characterized in that** the second converter comprises an array of switched capacitors (36), a switching circuit (35) for controlling the connection of capacitors of said array, and a second multiplexer (23) controlled by the second control signal (S_HL) supplied by said control signal generator (37), said second multiplexer receiving at its input the bottom voltage or current limit value of the dynamic range, the voltage or current thresholds for supplying a bottom voltage of the voltage range that has been determined to a second input of the switching circuit depending on the binary word supplied by the first converter, the binary word being defined by the state of the N-bit, preferably 2-bit, second control signal, and the first input of the swiching circuit receiving from the first multiplexer a top voltage or current of the voltage or current range that has been determined.

8. Conversion device according to claim 7, **characterized in that** the second converter comprises a third multiplexer (32) connected between the demultiplexer and the comparator, the third multiplexer being controlled by a third control signal (S_comp) supplied by the control signal generator in such a manner as to connect a terminal of the switched capacitor array to the comparator of the first converter in a conversion phase of the second converter, and **in that** the second converter operates between top and bottom voltages of the voltage range determined by the binary word supplied by the first converter to convert the voltage or current level to a number of bits less than or equal to M.

9. Image sensor comprising a pixel matrix photosensitive cell (2) for picking up an image to be digitised, at least one analog-digital conversion device according to any of the preceding claims, an illumination averaging unit (5) connected to the output of the conversion device, and a scale adapter (4) connected to the output of the conversion device and receiving a control signal from the averaging unit, **characterized in that** the conversion device comprises a plurality of first and second converters connected in parallel in such a manner that each converts to N + M bits a voltage or current signal supplied by a corresponding pixel, and **in that** the averaging unit receives the result of the conversion of the voltage or current level of each pixel to supply a control signal to the adapter in order for it to supply at its output a binary word of K bits selected from within each binary word of N + M bits supplied by the conversion device as a function of an illumination average determined by said averaging unit.

10. Image sensor according to claim 9, **characterized in that** the conversion device supplies a 10-bit binary word relating to the voltage or current level of each pixel and **in that** the scale adapter selects eight successive bits from each 10-bit binary word as a function of the illumination average determined by said averaging unit.

11. Analog-digital conversion method for operating the conversion device according to any of claims 1 to 8, in particular in an image sensor (11) that comprises a pixel matrix photosensitive cell (2) for picking up an image to be digitised, **characterized in that** it comprises a series of steps consisting in:

- comparing in the first converter the voltage or current level of the pixel with at least one voltage or current threshold delimiting successive voltage or current ranges within the dynamic range,
- supplying an N-bit binary word of more significant bits whose value relates to the voltage or current range in which the voltage or current level of the pixel is situated, the successive voltage or current ranges within the dynamic range being used to define the illumination of a pixel, ranging from a weakly illuminated pixel to a strongly illuminated pixel,
- configuring the second converter by the voltage or current range that has been determined between a minimum voltage or current and a maximum voltage or current of said voltage or current range as a function of the value of the N-bit binary word supplied of more significant bits by the first converter, and
- converting in the second converter the voltage or current level of the pixel to a number of less significant bits less than M without converting one or the last bits, which are the lowest, for a voltage or current range that has been determined corresponding to a moderately or strongly illuminated pixel or equal to M for a voltage or current range that has been determined corresponding to a weakly illuminated pixel.

12. Conversion method according to claim 11, **characterized in that** the first converter supplies a binary word comprising two more significant bits whose value represents one of four voltage ranges within the voltage dynamic range, the size of the first voltage range corresponding to a weakly illuminated pixel being smaller than the size of the voltage ranges corresponding to a moderately or strongly illuminated pixel, and **in that** the second converter effects conversion on 8 bits if the voltage level of the pixel is in a first voltage range corresponding to a weakly illuminated pixel, on 7 bits if the voltage level of the pixel is in a second voltage range corresponding to a moderately illuminated pixel, and on 6 bits if the voltage level of the pixel is in third or fourth voltage ranges corresponding to a strongly illuminated pixel, the less significant bits not converted by the second converter being defined arbitrarily so that conversion device supplies a 10-bit binary word.

13. Conversion method according to claim 11, **characterized in that** the first and second converters effect analog-digital conversion successively, thus enabling the use of a single comparator for comparison steps of both converters with the voltage or current thresholds of the dynamic range.

**Patentansprüche**

1. Analog/Digital-Umsetzungsvorrichtung (1) insbesondere für einen Bildaufnehmer (11), der eine photoempfindliche Zelle mit Pixelmatrix (2) umfasst, um ein zu digitalisierendes Bild aufzunehmen, wobei die Vorrichtung wenigstens einen ersten Umsetzer (21) mit N Bits und wenigstens einen zweiten Umsetzer (22) mit M Bits, der mit dem ersten Umsetzer verbunden ist, umfasst, wobei der erste und der zweite Umsetzer ermöglichen, einen Spannungs- oder Strompegel eines Spannungssignals (Vpix) oder eines Stromsignals, das von einem Pixel aus N + M Bits stammt, umzusetzen, wobei der umzusetzende Spannungs- oder Strompegel vom Pegel des durch das Pixel aufgenommenen Lichts in einem bestimmten dynamischen Spannungs- oder Strombereich (Vdyn) des Sensors abhängt, wobei der erste Umsetzer Vergleichsmittel (33) zum Vergleichen des Spannungs- oder Strompegels des Pixels mit einem oder mit mehreren Spannungsschwellenwerten (V0 bis V4) oder Stromschwellenwerten, die aufeinander folgende Spannungs- oder Strombereiche in dem dynamischen Bereich begrenzen, umfasst, um ein binäres Wort mit N höherwertigen Bits, dessen Wert auf den Spannungs- oder Strombereich bezogen ist, in dem sich der Spannungs- oder Strompegel des Pixels befindet, zu liefern, wobei die aufeinander folgenden Spannungs- oder Strombereiche in dem dynamischen Bereich ermöglichen, die Beleuchtung eines Pixels, die von einem schwach beleuchteten Pixel zu einem stark beleuchteten Pixel verläuft, zu definieren, **dadurch gekennzeichnet, dass** der zweite Umsetzer Umsetzungsanpassungsmittel (35) umfasst, die durch den bestimmten Spannungs- oder Strombereich zwischen einer minimalen Spannung oder einem minimalen Strom und einer maximalen Spannung oder einem maximalen Strom des Spannungs- oder Strombereichs in Abhängigkeit von dem Wert des binären Worts mit N höherwertigen Bits, das von dem ersten Umsetzer geliefert wird, konfiguriert werden, wobei die Umsetzungsanpassungsmittel konfiguriert sind, um eine Umsetzung des Spannungs- oder Stromsignals des Pixels in eine Anzahl von niedrigerwertigen Bits kleiner als M auszuführen, ohne das oder die letzten niedrigstwertigen Bits für einen bestimmten Spannungs- oder Strombereich eines stark beleuchteten Pixels umzusetzen, oder um für einen bestimmten Spannungs- oder Strombereich eines Pixels, das schwach beleuchtet wird, eine Umsetzung in eine Anzahl von niedrigerwertigen Bits, die gleich M ist, auszuführen.

2. Umsetzungsvorrichtung nach Anspruch 1, **dadurch gekennzeichnet, dass** sie ein Register umfasst, in dem die N höherwertigen Bits des nichtlinearen ersten Umsetzers und die M niedrigerwertigen Bits des linearen zweiten Umsetzers angeordnet sind.

3. Umsetzungsvorrichtung nach einem der vorhergehenden Ansprüche, **dadurch gekennzeichnet, dass** der erste Umsetzer ein binäres Wort mit zwei höherwertigen Bits, deren Wert einen von vier Spannungsbereichen des dynamischen Spannungsbereichs repräsentiert, liefert und dass die Umsetzungsanpassungsmittel des zweiten Umsetzers dem zweiten Umsetzer ermöglichen, eine Umsetzung an acht Bits in dem Fall auszuführen, in dem der Spannungspegel des Pixels in einem ersten Spannungsbereich eines schwach beleuchteten Pixels liegt, eine Umsetzung an sieben Bits in dem Fall auszuführen, in dem der Spannungspegel des Pixels in einem zweiten Spannungsbereich eines mittelmäßig beleuchteten Pixels liegt, und eine Umsetzung an sechs Bits in dem Fall auszuführen, in dem der Spannungspegel des Pixels in einem dritten oder vierten Spannungsbereich eines stark beleuchteten Pixels liegt, wobei die niedrigerwertigen Bits, die durch den zweiten Umsetzer nicht umgesetzt werden, beliebig in der Weise definiert sind, dass der erste und der zweite Umsetzer ein Binärwort mit zehn Bits liefern.

4. Umsetzungsvorrichtung nach einem der vorhergehenden Ansprüche, **dadurch gekennzeichnet, dass** sie so konfiguriert ist, dass die Größe jedes Spannungs- oder Strombereichs des dynamischen Bereichs von der Empfindlichkeit des Aufnehmers abhängt, wobei die Größe des Spannungsbereichs eines schwach beleuchteten Pixels kleiner als die Größe des Spannungsbereichs eines mittelmäßig oder stark beleuchteten Pixels ist, derart, dass die Empfindlichkeit des zweiten Umsetzers für Feinumsetzungsoperationen erhöht wird, derart, dass der Umsetzer eine Empfindlichkeit hat, die an jene des Aufnehmers angepasst ist.

5. Umsetzungsvorrichtung nach Anspruch 4, **dadurch gekennzeichnet, dass** die Größe des ersten Spannungsbereichs eines schwach beleuchteten Pixels in der Weise definiert ist, dass die Empfindlichkeit pro umgesetztem Bit des zweiten Umsetzers einer Empfindlichkeit pro äquivalentem Bit eines herkömmlichen linearen Umsetzers mit N + M + k Bits, insbesondere eines Umsetzers mit elf Bits über dem gesamten dynamischen Spannungs- oder Strombereich entspricht, und dass die Größe des letzten Spannungsbereichs eines stark beleuchteten Pixels in der Weise definiert ist, dass die Empfindlichkeit pro umgesetztem Bit des zweiten Umsetzers einer Empfindlichkeit pro im Wesentlichen äquivalentem Bit eines herkömmlichen linearen Umsetzers mit N + M - I Bits, insbesondere eines Umsetzers mit acht Bits über dem gesamten dynamischen Spannungs- oder Strombereich entspricht, um einen $2^{k-l}$-mal höheren und insbesondere 8-mal höheren Rauschfaktor eines stark beleuchteten Pixels gegenüber einem schwach beleuchteten Pixel zu berücksichtigen.

6. Umsetzungsvorrichtung nach Anspruch 1, **dadurch gekennzeichnet, dass** der erste Umsetzer einen Demultiplexer (31) umfasst, der durch ein erstes Steuersignal (S_in) gesteuert wird, das von einem Steuersignalgenerator geliefert wird, um das Spannungssignal (Vpix) oder das Stromsignal eines Pixels mit einem ersten Eingang der Vergleichsmittel wie etwa eines Komparators (33) oder mit einem ersten Eingang einer Umschaltschaltung (35) des zweiten Umsetzers in einer Ladephase zu verbinden, wobei ein erster Multiplexer (24) am Eingang die Spannungs- oder Stromschwellenwerte empfängt, die die Spannungs- oder Strombereiche und den oberen Spannungs- oder Stromgrenzwert des dynamischen Bereichs begrenzen, wobei der erste Muliplexer durch ein zweites Steuersignal (S_HL) gesteuert wird, das von dem Steuersignalgenerator (37) geliefert wird, um einen der Spannungs- oder Stromschwellenwerte mit einem zweiten Eingang des Komparators zu verbinden, wobei der Ausgang des Komparators mit dem Steuersignalgenerator verbunden ist, um den Zustand des zweiten Steuersignals in Abhängigkeit vom Ergebnis des Vergleichs zwischen dem Spannungs- oder Stromsignal des Pixels mit einem Schwellenspannungspegel oder Schwellenstrompegel abzuwandeln oder beizubehalten.

7. Umsetzungsvorrichtung nach Anspruch 6, **dadurch gekennzeichnet, dass** der zweite Umsetzer ein Netzwerk (36) aus geschalteten Kapazitäten, die Umschaltschaltung (35) zum Steuern der Verbindung der Kapazitäten des Netzwerks und einen zweiten Multiplexer (23), der durch das von dem Steuersignalgenerator (37) gelieferte zweite Steuersignal (S_HL) gesteuert wird, umfasst, wobei der zweite Multiplexer am Eingang den unteren Spannungs- oder Stromgrenzwert des dynamischen Bereichs und die Spannungs- oder Stromschwellenwerte empfängt, um eine untere Spannung oder einen unteren Strom des bestimmten Spannungs- oder Strombereichs an einen zweiten Eingang der Umschaltschaltung in Abhängigkeit von dem von dem ersten Umsetzer gelieferten Binärwort zu liefern, wobei das Binärwort durch den Zustand des zweiten Steuersignals mit N Bits, vorzugsweise mit zwei Bits, definiert ist, wobei der erste Eingang der Umschaltschaltung eine obere Spannung oder einen oberen Strom des bestimmten Spannungs- oder Strombereichs, die bzw. der vom ersten Multiplexer geliefert wird, empfängt.

8. Umsetzungsvorrichtung nach Anspruch 7, **dadurch gekennzeichnet, dass** der zweite Umsetzer einen dritten Multiplexer (32) umfasst, der zwischen den Demultiplexer und den Komparator geschaltet ist, wobei der dritte Multiplexer durch ein drittes Steuersignal (S_comp) gesteuert wird, das von den Steuersignalgenerator geliefert wird, derart, dass ein Anschluss des Netzwerks mit geschalteten Kapazitäten mit dem Komparator des ersten Umsetzers in einer Umsetzungsphase des zweiten Umsetzers verbunden wird, und dass der zweite Umsetzer zwischen der oberen und unteren Spannung des durch das von dem ersten Umsetzer gelieferte Binärwort bestimmten Spannungsbereichs arbeitet, um den Spannungs- oder Strompegel in eine Anzahl von Bits, die kleiner oder gleich M ist, umzusetzen.

9. Bildaufnehmer, der eine photoempfindliche Zelle mit Pixelmatrix (2), um ein zu digitalisierendes Bild aufzunehmen, wenigstens eine Analog/Digital-Umsetzungsvorrichtung nach einem der vorhergehenden Ansprüche, eine mit dem Ausgang der Vorrichtung verbundene Beleuchtungsmittelwertbildungseinrichtung (5) und einen Skalenadapter (4), der mit dem Ausgang der Vorrichtung verbunden ist und ein Steuersignal der Mittelwertbildungseinrichtung empfängt, umfasst, **dadurch gekennzeichnet, dass** die Vorrichtung mehrere erste und zweite Umsetzer umfasst, die parallel geschaltet sind, derart, dass sie jeweils an N + M Bits ein Spannungs- oder Stromsignal umsetzen, das von einem entsprechenden Pixel geliefert wird, und dass die Mittelwertbildungseinrichtung das Ergebnis der Umsetzung des Spannungs- oder Strompegels jedes Pixels empfängt, um ein Steuersignal an den Adapter zu liefern, damit er am Ausgang ein Binärwort mit K Bits, die in jedem Binärwort aus N + M Bits ausgewählt werden, die ihrerseits von der Vorrichtung in Abhängigkeit von einem durch die Mittelwertbildungseinrichtung bestimmten Beleuchtungsmittelwert geliefert werden, liefert.

10. Bildaufnehmer nach Anspruch 9, **dadurch gekennzeichnet, dass** die Umsetzungsvorrichtung ein Binärwort mit zehn Bits in Bezug auf den Spannungs- oder Strompegel jedes Pixels liefert und dass der Skalenadapter acht aufeinander folgende Bits jedes Binärworts mit zehn Bits in Abhängigkeit von dem durch die Mittelwertbildungseinrichtung bestimmten Beleuchtungsmittelwert auswählt.

11. Verfahren zur Analog/Digital-Umsetzung insbesondere eines Bildaufnehmers (11), der eine photoempfindliche Zelle (2) mit Pixelmatrix umfasst, um ein zu digitalisierendes Bild aufzunehmen, um die Umsetzungsvorrichtung nach einem der Ansprüche 1 bis 8 zu betreiben, **dadurch gekennzeichnet, dass** es eine Reihe von Schritten umfasst, die darin bestehen:

- in einem ersten Umsetzer den Spannungs- oder Strompegel des Pixels mit wenigstens einer Schwellenspannung oder einem Schwellenstrom des dynamischen Bereichs, der aufeinander folgende Spannungs- oder Strombereiche begrenzt, zu vergleichen,
- ein Binärwort mit N höherwertigen Bits, dessen Wert auf den Spannungs- oder Strombereich bezogen ist, in dem sich der Spannungs- oder Strompegel des Pixels befindet, zu liefern, wobei die aufeinander folgenden Spannungs- oder Strombereiche in dem dynamischen Bereich ermöglichen, die Beleuchtung eines Pixels im Bereich von einem schwach beleuchteten Pixel zu einem stark beleuchteten Pixel zu definieren,
- den zweiten Umsetzer durch den bestimmten Spannungs- oder Strombereich zwischen einer minimalen Spannung bzw. einem minimalen Strom oder einer maximalen Spannung bzw. einem maximalen Strom des Spannungs- oder Strombereichs in Abhängigkeit von dem Wert des Binärworts mit N höherwertigen Bits, das von dem ersten Umsetzer geliefert wird, zu konfigurieren, und
- in dem zweiten Umsetzer den Spannungs- oder Strompegel des Pixels an einer Anzahl von niedrigerwertigen Bits, die kleiner als M ist, umzusetzen, ohne das oder die letzten niedrigstwertigen Bits für einen bestimmten Spannungs- oder Strombereich eines mittelmäßig oder stark beleuchteten Pixels umzusetzen, oder an einer Anzahl, die gleich M ist, für einen bestimmten Spannungs- oder Strombereich eines Pixels, das schwach beleuchtet ist, umzusetzen.

12. Umsetzungsverfahren nach Anspruch 11, **dadurch gekennzeichnet, dass** der erste Umsetzer ein Binärwort mit zwei höherwertigen Bits liefert, dessen Wert einen von vier Spannungsbereichen des dynamischen Spannungsbereichs angibt, wobei die Größe des ersten Spannungsbereichs eines schwach beleuchteten Pixels kleiner als die Größe der Spannungsbereiche eines mittelmäßig oder stark beleuchteten Pixels ist, und dass der zweite Umsetzer eine Umsetzung an acht Bits in dem Fall ausführt, in dem der Spannungspegel des Pixels in einem ersten Spannungsbereich eines schwach beleuchteten Pixels liegt, eine Umsetzung an sieben Bits in dem Fall ausführt, in dem der Spannungspegel des Pixels in einem zweiten Spannungsbereich eines mittelmäßig beleuchteten Pixels liegt, und eine Umsetzung an sechs Bits in dem Fall ausführt, in dem der Spannungspegel des Pixels in einem dritten oder einem vierten Spannungsbereich eines stark beleuchteten Pixels liegt, wobei die niedrigerwertigen Bits, die durch den zweiten Umsetzer nicht umgesetzt werden, beliebig definiert sind, damit die Vorrichtung ein Binärwort mit zehn Bits liefert.

13. Umsetzungsverfahren nach Anspruch 11, **dadurch gekennzeichnet, dass** der erste und der zweite Umsetzer die Analog/Digital-Umsetzung nacheinander ausführen, um nur einen einzigen Komparator für die Vergleichsschritte der zwei Umsetzer mit Spannungs- oder Strom-Schwellenwerten des dynamischen Bereichs zu verwenden.

Fig.1a
(art antérieur)

Fig.1b
(art antérieur)

Fig.2

Fig.3

Fig.4

Fig.5

Fig. 6

Fig.7a

Fig.7b

50 — Sample
& Hold

Phase de précharge

51 — ◇ Vpix<V1 — Vrai → 52 — MSB=00 — nmin=1

Faux

53 — ◇ Vpix<V2 — Vrai → 54 — MSB=01 — nmin=2

Faux

55 — ◇ Vpix<V3 — Vrai → 56 — MSB=10 — nmin=3

Faux

57 — MSB=11 — nmin=3

Conversion grossière

58 — Charge
capacités

Phase de charge

59 — n=8

Conversion fine

60 — Commuter bit #n de
Vsup à Vinf → 61 — ◇ Vcap<Vsup — Faux

Vrai

62 — Commuter bit #n de
Vinf à Vsup

64 — n = n-1

63 — ◇ n ≤ nmin
Conversion
finie? — Faux

Vrai

Fig.8

**EP 1 484 911 B1**

## RÉFÉRENCES CITÉES DANS LA DESCRIPTION

**Documents brevets cités dans la description**

- US 4733217 A